# EUROPÄISCHE PATENTSCHRIFT

(11) **EP 3 791 219 B1**
(45) Veröffentlichungstag und Bekanntmachung des Hinweises auf die Patenterteilung: **16.02.2022**
(21) Anmeldenummer: 19725930.2
(22) Anmeldetag: 24.04.2019
(51) Int. Cl.: G02B 5/08, G02B 26/08, G03F 7/20, G21K 1/06, G02B 27/00

(54) **SPIEGEL, INSBESONDERE FÜR EINE MIKROLITHOGRAPHISCHE PROJEKTIONSBELICHTUNGSANLAGE**
MIRROR, IN PARTICULAR FOR A MICROLITHOGRAPHIC PROJECTION EXPOSURE SYSTEM
MIROIR, NOTAMMENT POUR SYSTÈME D'EXPOSITION PAR PROJECTION MICROLITHOGRAPHIQUE

(30) Priorität: 08.05.2018 DE 102018207146
(43) Veröffentlichungstag der Anmeldung: 17.03.2021
(73) Patentinhaber: Carl Zeiss SMT GmbH, 73447 Oberkochen (DE)
(72) Erfinder: HILD, Kerstin, 73550 Waldstetten (DE); GRUNER, Toralf, 73433 Aalen (DE); SHKLOVER, Vitaliy, 89522 Heidenheim (DE)
(74) Vertreter: Frank, Hartmut
(86) Internationale Anmeldenummer: PCT/EP2019/060523
(87) Internationale Veröffentlichungsnummer: WO 2019/214946

(56) Entgegenhaltungen:
- DE-A1-102011 081 603
- DE-A1-102015 213 273

## Beschreibung

### Gebiet der Erfindung

Die Erfindung betrifft einen Spiegel, insbesondere für eine mikrolithographische Projektionsbelichtungsanlage.

### Stand der Technik

Mikrolithographie wird zur Herstellung mikrostrukturierter Bauelemente, wie beispielsweise integrierter Schaltkreise oder LCDs, angewendet. Der Mikrolithographieprozess wird in einer sogenannten Projektionsbelichtungsanlage durchgeführt, welche eine Beleuchtungseinrichtung und ein Projektionsobjektiv aufweist. Das Bild einer mittels der Beleuchtungseinrichtung beleuchteten Maske (= Retikel) wird hierbei mittels des Projektionsobjektivs auf ein mit einer lichtempfindlichen Schicht (= Photoresist) beschichtetes und in der Bildebene des Projektionsobjektivs angeordnetes Substrat (z.B. einen Siliziumwafer) projiziert, um die Maskenstruktur auf die lichtempfindliche Beschichtung des Substrats zu übertragen.

In für den EUV-Bereich ausgelegten Projektionsobjektiven, d.h. bei Wellenlängen von z.B. etwa 13 nm oder etwa 7 nm, werden mangels Verfügbarkeit geeigneter lichtdurchlässiger refraktiver Materialien Spiegel als optische Komponenten für den Abbildungsprozess verwendet.

Dabei ist es auch bekannt, einen oder mehrere Spiegel in einem EUV-System als adaptiven Spiegel mit einer Aktuatorschicht aus einem piezoelektrischen Material auszugestalten, wobei über diese piezoelektrische Schicht hinweg ein elektrisches Feld mit lokal unterschiedlicher Stärke durch Anlegen einer elektrischen Spannung an beiderseitig zur piezoelektrischen Schicht angeordnete Elektroden erzeugt wird. Bei lokaler Verformung der piezoelektrischen Schicht verformt sich auch der Reflexionsschichtstapel des adaptiven Spiegels, so dass durch geeignete Ansteuerung der Elektroden beispielsweise Abbildungsfehler (ggf. auch zeitlich veränderliche Abbildungsfehler) wenigstens teilweise kompensiert werden können.

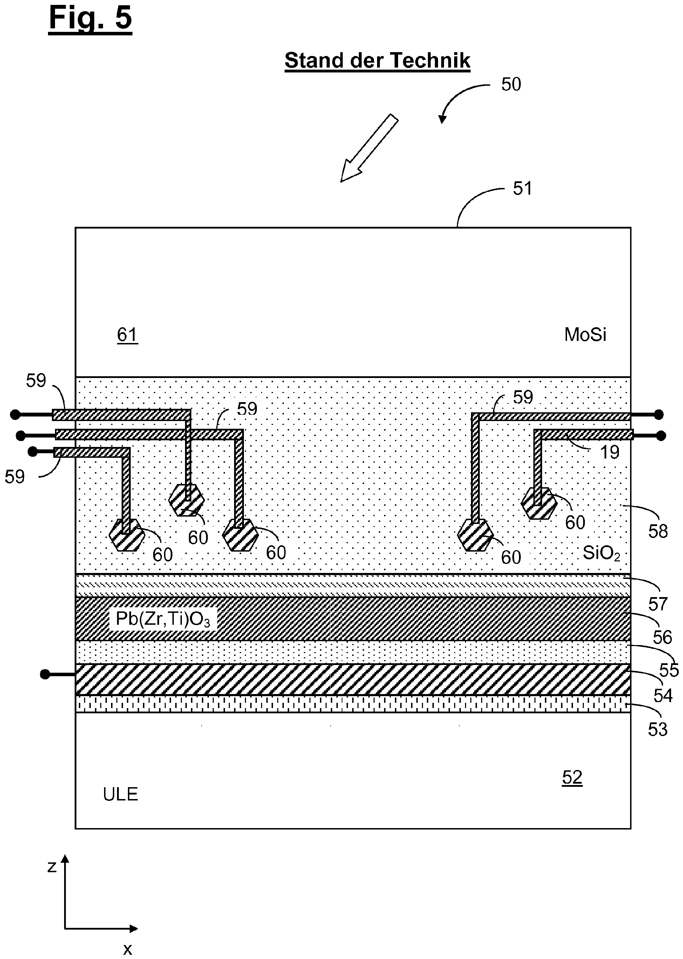

Fig. 5 zeigt in lediglich schematischer Darstellung einen prinzipiell möglichen Aufbau eines herkömmlichen adaptiven Spiegels 50. Der Spiegel 50 umfasst insbesondere ein Spiegelsubstrat 52 sowie einen Reflexionsschichtstapel 61 und weist eine piezoelektrische Schicht 56 auf, welche im Beispiel aus Blei-Zirkonat-Titanat (Pb(Zr,Ti)O₃, PZT) hergestellt ist. Ober- bzw. unterhalb der piezoelektrischen Schicht 56 befinden sich Elektrodenanordnungen, über welche der Spiegel 50 mit einem elektrischen Feld zur Erzeugung einer lokal variablen Deformation beaufschlagbar ist. Von diesen Elektrodenanordnungen ist die zweite, dem Substrat 52 zugewandte Elektrodenanordnung als durchgehende, flächige Elektrode 54 von konstanter Dicke ausgestaltet, wohingegen die erste Elektrodenanordnung eine Mehrzahl von Elektroden 60 aufweist, welche jeweils über eine Zuleitung 59 mit einer elektrischen Spannung relativ zur Elektrode 54 beaufschlagbar sind. Die Elektroden 60 sind in eine gemeinsame Glättschicht 58 eingebettet, welche z.B. aus Quarz (SiO₂) hergestellt ist und zur Einebnung der aus den Elektroden 60 gebildeten Elektrodenanordnung dient. Des Weiteren weist der Spiegel 50 zwischen dem Spiegelsubstrat 52 und der dem Spiegelsubstrat 52 zugewandten unteren Elektrode 54 eine Haftschicht 53 (z.B. aus Titan, Ti) und eine zwischen der dem Substrat 52 zugewandten Elektrodenanordnung 54 und der piezoelektrischen Schicht 56 angeordnete Pufferschicht 55 (z.B. aus LaNiO₃) auf, welche das Aufwachsen von PZT in optimaler, kristalliner Struktur weiter unterstützt und gleichbleibende Polarisationseigenschaften der piezoelektrischen Schicht über die Lebensdauer sicherstellt.

Im Betrieb des Spiegels 50 bzw. eines diesen Spiegel 50 aufweisenden optischen Systems führt das Anlegen einer elektrischen Spannung an die Elektroden 54 und 60 über das sich ausbildende elektrische Feld zu einer Auslenkung der piezoelektrischen Schicht 56. Auf diese Weise kann - etwa zur Kompensation von optischen Aberrationen z.B. infolge thermischer Deformationen bei auf die optische Wirkfläche 51 auftreffender EUV-Strahlung - eine Aktuierung des Spiegels 50 erzielt werden.

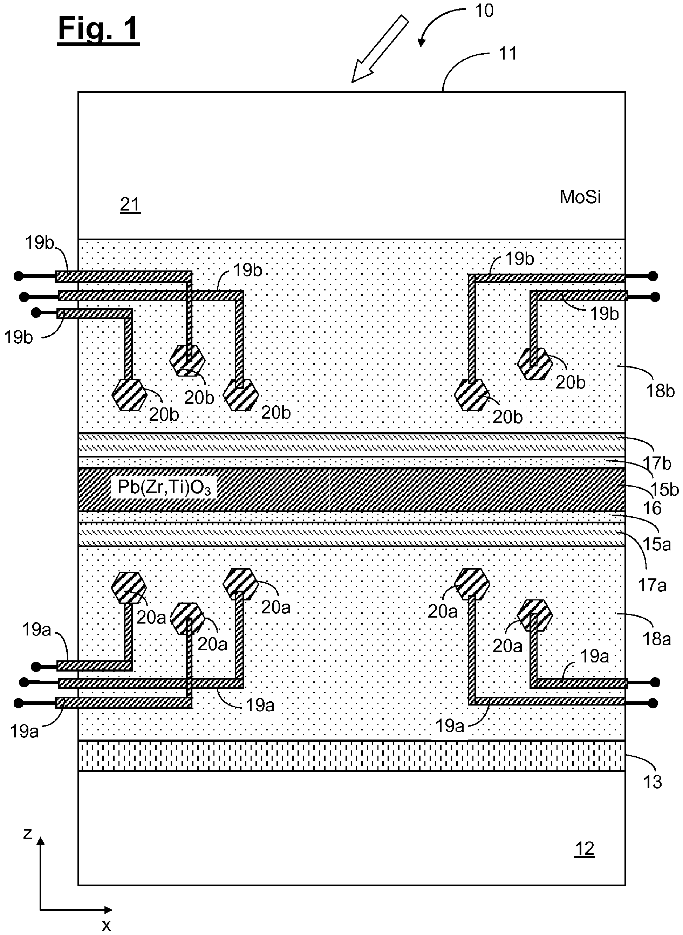

Gemäß Fig. 5 weist der Spiegel 50 ferner eine Vermittlerschicht 57 auf. Diese Vermittlerschicht 57 steht in direktem elektrischem Kontakt zu den Elektroden 60 (welche in Fig. 1 nur zur Veranschaulichung in Draufsicht dargestellt sind). Diese Vermittlerschicht 57 dient dazu, zwischen den Elektroden 60 im Potential zu "vermitteln", wobei sie eine nur geringe elektrische Leitfähigkeit (vorzugsweise weniger als 200 Siemens/Meter (S/m)) aufweist mit der Folge, dass ein zwischen benachbarten Elektroden 60 bestehender Spannungsunterschied im Wesentlichen über der Vermittlerschicht 57 abfällt.

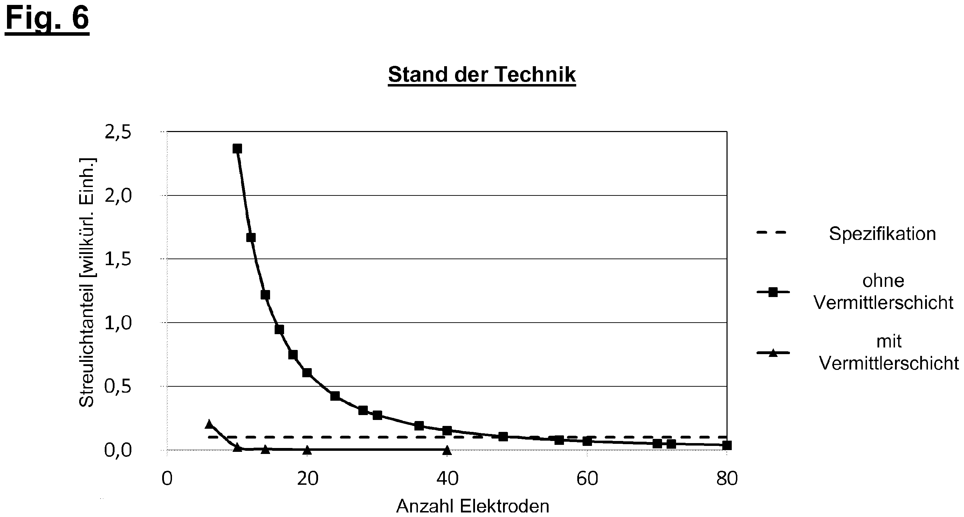

Ein aufgrund des Vorhandenseins der Vermittlerschicht 57 erzielter Vorteil ist aus dem Diagramm von Fig. 6 ersichtlich, in welchem der Streulichtanteil in Abhängigkeit von der Anzahl der Elektroden 60 aufgetragen ist. Gemäß Fig. 6 ist zur Unterschreitung einer nach einer beispielhaften Spezifikation vorgegebenen oberen Schwelle für den Streulichtanteil ohne Vorhandensein der Vermittlerschicht 57 in dem gewählten Beispiel eine Anzahl von sechzig Elektroden in einer von zwei zueinander senkrechten Raumrichtungen erforderlich, insgesamt also eine Anzahl von 60*60=3.600 Elektroden, wohingegen diese Anzahl bei Vorhandensein der Vermittlerschicht 57 auf weniger als zehn Elektroden in einer der zwei zueinander senkrechten Raumrichtungen reduziert werden kann mit der Folge, dass die Realisierbarkeit der aus den Elektroden 60 gebildeten Elektrodenanordnung wesentlich vereinfacht wird.

Da die vorstehend beschriebene Beaufschlagung der Elektrodenanordnungen mit elektrischer Spannung im adaptiven Spiegel zu einem elektrischen Strom in der Vermittlerschicht 57 und damit über die hierdurch generierte elektrische Leistung zu einer unerwünschten Wärmeentwicklung führt, ist es grundsätzlich wünschenswert, die besagte elektrische Leistung durch Einstellung eines ausreichend hohen elektrischen Widerstandes der Vermittlerschicht (von z.B. 100kΩ) zu begrenzen. Wenngleich eine solche Ausgestaltung für bestimmte Einsatzszenarien des adaptiven Spiegels wie z.B. zur Korrektur des Einflusses von thermisch durch Strahlungsabsorption induzierten Deformationen der optischen Elemente wie Spiegel oder Linsen geeignet sein können, existieren in der Praxis auch Szenarien, bei denen die Einstellung der gewünschten Oberflächenform des adaptiven Spiegels auf wesentlich kürzerer Zeitskala, z.B. innerhalb von Millisekunden (ms), zu erfolgen hat.

Zu solchen Szenarien, bei denen die Ausbreitung des elektrischen Potentials in einer Vermittlerschicht mit den vorstehend genannten hohen Widerständen zur Begrenzung der elektrischen Leistung zu langsam erfolgen würde, gehört z.B. die Berücksichtigung thermisch induzierter Maskendeformationen im Lithographieprozess, bei denen die Maske in Folge der Absorption von größenordnungsmäßig mehr als 30% des EUV-Lichts ein irreguläres "Gebirge" ausbildet, welches letztlich eine Fokusvariation im lithographischen Abbildungsprozess zur Folge hat.

Die Berücksichtigung der vorstehend beschriebenen Variation der Oberflächenform der Maske durch entsprechende Einstellung des adaptiven Spiegels muss im Lithographieprozess bereits während eines (z.B. größenordnungsmäßig 100ms dauernden) Scanvorgangs und damit auf einer vergleichsweise kleinen Zeitskala von Millisekunden (ms) stattfinden. Wenngleich die entsprechende Ansteuerung der Elektroden im adaptiven Spiegel ohne Weiteres realisierbar ist, erweist sich die praktische Umsetzung der besagten geringen Zeitkonstanten hinsichtlich der Vermittlerschicht als problematisch, da eine Verringerung des elektrischen Widerstandes der Vermittlerschicht infolge der diesbezüglich reziproken Abhängigkeit der elektrischen Leistung wiederum thermische Probleme zur Folge hat.

Zum Stand der Technik wird lediglich beispielhaft auf DE 10 2013 219 583 A1 und DE 10 2015 213 273 A1 verwiesen. Insbesondere die DE 10 2015 213273 A1 offenbart einen Spiegel umfassend eine piezoelektrische Schicht und eine Elektrodenanordnung, die Elektroden aufweist die mit einem elektrischen Feld zur Erzeugung einer lokal variablen Deformation beaufschlagbar sind. Eine separate Vermittlerschicht ist der Elektrodenanordnung zugeordnet zur Einstellung eines kontinuierlichen Verlaufs des elektrischen Potentials entlang der Elektrodenanordnung. Es wird auch ein optisches System einer mikrolithographischen Projektionsbelichtungsanlage offenbart.

### ZUSAMMENFASSUNG DER ERFINDUNG

Es ist eine Aufgabe der vorliegenden Erfindung, einen Spiegel, insbesondere für eine mikrolithographische Projektionsbelichtungsanlage, bereitzustellen, welcher basierend auf dem Prinzip der lokal variierenden Deformation einer piezoelektrischen Schicht eine möglichst optimale Korrektur von Aberrationen unterschiedlicher Art bei zugleich möglichst geringer Wärmeerzeugung im optischen System ermöglicht.

Diese Aufgabe wird gemäß den Merkmalen der unabhängigen Patentansprüche gelöst.

Ein erfindungsgemäßer Spiegel weist auf:
- eine optische Wirkfläche,
- ein Spiegelsubstrat;
- einen Reflexionsschichtstapel zur Reflexion von auf die optische Wirkfläche auftreffender elektromagnetischer Strahlung; und
- wenigstens eine piezoelektrische Schicht, welche zwischen Spiegelsubstrat und Reflexionsschichtstapel angeordnet und über eine erste, auf der dem Reflexionsschichtstapel zugewandten Seite der piezoelektrischen Schicht befindliche Elektrodenanordnung und eine zweite, auf der dem Spiegelsubstrat zugewandten Seite der piezoelektrischen Schicht befindliche
Elektrodenanordnung mit einem elektrischen Feld zur Erzeugung einer lokal variablen Deformation beaufschlagbar ist;
- wobei sowohl die erste Elektrodenanordnung als auch die zweite Elektrodenanordnung eine Mehrzahl von Elektroden aufweist, welche jeweils über eine Zuleitung mit einer elektrischen Spannung bezogen auf die jeweils andere Elektrodenanordnung beaufschlagbar sind;
- wobei jeder dieser Elektrodenanordnungen jeweils eine separate Vermittlerschicht zur Einstellung eines kontinuierlichen Verlaufs des elektrischen Potentials entlang der jeweiligen Elektrodenanordnung zugeordnet ist; und
- wobei sich diese Vermittlerschichten in ihrem mittleren elektrischen Widerstand um einen Faktor von wenigstens 1.5 voneinander unterscheiden.

Der vorliegenden Erfindung liegt insbesondere das Konzept zugrunde, bei einem adaptiven Spiegel mit einer über Elektrodenanordnungen mit einem elektrischen Feld zur Erzeugung einer lokal variablen Deformation beaufschlagbaren piezoelektrischen Schicht zur Vermittlung im Potential zwischen den jeweiligen Elektroden einer Elektrodenanordnung nicht nur eine einzige Vermittlerschicht mit vergleichsweise geringer elektrischer Leitfähigkeit einzusetzen, sondern von vorneherein zwei separate Vermittlerschichten zu verwenden, wodurch im Wege einer im Weiteren beschriebenen Aufgabenteilung den im praktischen Betrieb auftretenden unterschiedlichen Anforderungen bzw. Einsatzszenarien jeweils gezielt und ohne unerwünschte Inkaufnahme von Kompromissen (etwa hinsichtlich thermischer Probleme) Rechnung getragen werden kann.

Insbesondere beinhaltet die Erfindung hierbei das Konzept, eine von zwei separaten und unterschiedlichen Vermittlerschichten zur Realisierung einer vergleichsweise schnellen Potentialausbreitung innerhalb der Vermittlerschicht mit vergleichsweise geringem elektrischen Widerstand (z.B. mit einem elektrischen Widerstand von 1 Kiloohm (kΩ) zur Realisierung einer Umschaltzeit hinsichtlich des elektrischen Potentials von 100ms) und die zweite separate Vermittlerschicht mit wesentlich größerem elektrischen Widerstand (z.B. 100kΩ) auszulegen, um insoweit die Generierung elektrischer Leistung möglichst zu begrenzen und hierbei vergleichsweise größere Umschaltzeiten hinsichtlich des sich in der Vermittlerschicht jeweils einstellenden elektrischen Potentials (z.B. Umschaltzeiten von größenordnungsmäßig 10s oder mehr) in Kauf zu nehmen.

Dem vorstehend beschriebenen erfindungsgemäßen Konzept liegt die weitere Überlegung zugrunde, dass in den typischen Anwendungsszenarien für die zuerst genannte, einen vergleichsweise geringen elektrischen Widerstand aufweisende und damit ein schnelles Umschalten hinsichtlich des elektrischen Potentials bzw. hinsichtlich der Wirkung des adaptiven Spiegels ermöglichende Vermittlerschicht, wie z.B. bei der Anwendung zur Berücksichtigung thermisch induzierter Maskendeformationen im Lithographieprozess, die typischerweise erforderlichen (Deformations-) Amplituden vergleichsweise gering sind und lediglich beispielhaft in der Größenordnung von 1nm liegen können.

Demgegenüber sind die bei dem ebenfalls vorstehend beschriebenen Einsatzszenario der Korrektur des Einflusses von thermisch durch Strahlungsabsorption induzierten Deformation optischer Elemente wie Spiegel oder Linsen typischerweise benötigten (Deformations-) Amplituden vergleichsweise größer und können z.B. in der Größenordnung von 10nm liegen.

Die somit vorhandenen Unterschiede hinsichtlich der Größenordnung der bei den unterschiedlichen Einsatzszenarien jeweils einzustellenden Deformationsamplituden können nun im Rahmen der Erfindung dahingehend genutzt werden, dass zur Korrektur des Einflusses thermisch induzierter Deformationen z.B. von Spiegeln zwar vergleichsweise große Gradienten der elektrischen Spannung auf Seiten der betreffenden (vergleichsweise höherohmigen) Vermittlerschicht benötigt werden, jedoch auch ein wesentlich größerer elektrischer Widerstand in Kauf genommen werden kann, da vergleichsweise mehr Zeit zum Umschalten zwischen den jeweiligen elektrischen Potentialen zur Verfügung steht. Hingegen kann für das Anwendungsszenario der Berücksichtigung thermisch induzierter Maskendeformationen im Lithographieprozess die vergleichsweise niedrigohmige (z.B. einen elektrischen Widerstand von 1kΩ aufweisende) Vermittlerschicht genutzt werden, da insofern nur vergleichsweise geringe Deformationsamplituden und somit auch geringe Gradienten der elektrischen Spannung benötigt werden und die mit elektrischem Stromfluss einhergehende Wärmeentwicklung damit von vorneherein signifikant begrenzt wird.

Zusammenfassend erfolgt gemäß einem Aspekt der Erfindung eine funktionale Aufteilung auf zwei voneinander separate Vermittlerschichten, von denen die eine Vermittlerschicht für einen "schnellen Betrieb" (d.h. Umschaltung zwischen unterschiedlichen elektrischen Potentialen auf vergleichsweise kurzer Zeitskala von z.B. größenordnungsmäßig 1ms) mit geringer Amplitude (z.B. größenordnungsmäßig 1nm) und die andere Vermittlerschicht für einen vergleichweise "langsamen Betrieb" (z.B. Umschaltung zwischen unterschiedlichen elektrischen Potentialen auf längerer Zeitskala von größenordnungsmäßig 10s) mit vergleichweise großer Amplitude (z.b. 10nm) ausgelegt ist.

Beide Vermittlerschichten sind hinsichtlich der elektrischen Spannung unabhängig voneinander ansteuerbar, wobei ausschlaggebend für die in der piezoelektrischen Schicht eingestellte lokal variierende Deformation wiederum die Potentialdifferenz zwischen den über die beiden Vermittlerschichten eingestellten elektrischen Potentialen ist.

Mit anderen Worten wird im Betrieb des erfindungsgemäßen adaptiven Spiegels abhängig davon, welcher Effekt gerade durch die eingestellte lokal variable Deformation des adaptiven Spiegels korrigiert werden soll, die eine oder die andere Vermittlerschicht (gegebenenfalls auch eine geeignete Kombination) zur Erzeugung der entsprechenden Deformation verwendet.

Dabei wird erfindungsgemäß aufgrund des Umstandes, dass für beide erfindungsgemäß eingesetzten Vermittlerschichten jeweils strukturierte Elektrodenanordnungen benötigt werden, bewusst ein in fertigungstechnischer Hinsicht höherer Aufwand etwa im Vergleich zu einem herkömmmlichen, mit nur einer Vermittlerschicht auskommenden Aufbau z.B. gemäß Fig. 5 (bei welchem eine Elektrodenanordnung als flächige Elektrode ausgebildet werden kann und somit nur eine strukturierte Elektrodenanordnung benötigt wird) in Kauf genommen.

Die Inkaufnahme dieses Nachteils erfolgt erfindungsgemäß, um im Gegenzug durch die vorstehend beschriebene Aufgabenteilung hinsichtlich der beiden erfindungsgemäßen Vermittlerschichten gezielt den in unterschiedlichen Anwendungsszenarien jeweils bestehenden Anforderungen gerecht werden zu können und dabei im Ergebnis eine möglichst optimale Korrektur von Aberrationen bei zugleich möglichst geringer Wärmeerzeugung im optischen System zu realisieren.

Gemäß einer Ausführungsform unterscheiden sich die Vermittlerschichten in ihrem mittleren elektrischen Widerstand um einen Faktor von wenigstens 3, insbesondere um einen Faktor von wenigstens 5, voneinander.

Gemäß einer Ausführungsform unterscheiden sich die Vermittlerschichten in ihrer mittleren Dicke voneinander (wobei der unterschiedliche elektrische Widerstand insbesondere bei Verwendung identischer Materialien für die Vermittlerschicht durch unterschiedliche Dicken bereitgestellt werden kann).

Gemäß einer Ausführungsform unterscheiden sich die Vermittlerschichten hinsichtlich ihrer Stöchiometrie voneinander (wobei der unterschiedliche elektrische Widerstand insbesondere mit gleichen Dicken durch Verwendung unterschiedlicher Materialien für die Vermittlerschicht bereitgestellt werden kann). Dabei kann insbesondere ein Unterschied in der Stöchiometrie auch bei gleichem Material und gleicher Dicke hergestellt werden, indem der Hintergrund-Druck bei der Deposition variiert, der Sauerstoff-Partialdruck variiert oder die Depositionstemperatur angepasst wird.

Gemäß einer Ausführungsform weist das Material wenigstens einer der Vermittlerschichten Titandioxid (TiO₂), LaCoO₃, LaMnO₃, LaCaMnO₃ oder LaNiO₃ auf.

Gemäß einem weiteren Aspekt betrifft die Erfindung auch einen Spiegel, insbesondere für eine mikrolithographische Projektionsbelichtungsanlage, wobei der Spiegel eine optische Wirkfläche aufweist, mit
- einem Spiegelsubstrat,
- einem Reflexionsschichtstapel zur Reflexion von auf die optische Wirkfläche auftreffender elektromagnetischer Strahlung,
- wenigstens einer piezoelektrischen Schicht, welche zwischen Spiegelsubstrat und Reflexionsschichtstapel angeordnet und über eine erste, auf der dem Reflexionsschichtstapel zugewandten Seite der piezoelektrischen Schicht befindliche Elektrodenanordnung und eine zweite, auf der dem Spiegelsubstrat zugewandten Seite der piezoelektrischen Schicht befindliche Elektrodenanordnung mit einem elektrischen Feld zur Erzeugung einer lokal variablen Deformation beaufschlagbar ist,
- wobei wenigstens einer dieser Elektrodenanordnungen eine Vermittlerschicht mit steuerbarer elektrischer Leitfähigkeit zur zeitlich variablen Einstellung eines kontinuierlichen Verlaufs des elektrischen Potentials entlang der jeweiligen Elektrodenanordnung zugeordnet ist.

Gemäß einer Ausführungsform weist der Spiegel wenigstens eine Steuerelektrode, insbesondere eine Mehrzahl von unabhängig voneinander betreibbaren Steuerelektroden, zur Steuerung der elektrischen Leitfähigkeit der Vermittlerschicht auf.

Über diese Ausgestaltung kann die elektrische Spannung der Vermittlerschicht zeitlich variabel eingestellt werden. Dabei kann eine vergleichsweise größere elektrische Leitfähigkeit bzw. ein geringerer mittlerer elektrischer Widerstand zur Einstellung von vergleichsweise geringeren Deformationsamplituden auf kürzerer Zeitskala dienen, wohingegen die elektrische Leifähigkeit zur Einstellung vergleichsweise höherer Deformationsamplituden auf größerer Zeitskala dann entsprechend herabgesetzt werden kann.

Bei dem Spiegel kann es sich insbesondere um einen Spiegel für eine mikrolithographische Projektionsbelichtungsanlage handeln. Die Erfindung ist jedoch nicht hierauf beschränkt. In weiteren Anwendungen kann ein erfindungsgemäßer Spiegel auch z.B. in einer Anlage für Maskenmetrologie eingesetzt bzw. verwendet werden.

Gemäß einer Ausführungsform ist der Spiegel für eine Arbeitswellenlänge von weniger als 30nm, insbesondere weniger als 15nm, ausgelegt. Die Erfindung ist jedoch hierauf nicht beschränkt, so dass in weiteren Anwendungen die Erfindung auch in einem optischen System mit einer Arbeitswellenlänge im VUV-Bereich (z.B. von weniger als 200nm) vorteilhaft realisiert werden kann.

Das erfindungsgemäße Konzept des Einsatzes zweier separater Vermittlerschichten zur Erzielung der vorstehend beschriebenen Aufgabenteilung ist nicht auf die Realisierung in ein- und demselben adaptiven Spiegel beschränkt. Vielmehr können die beiden erfindungsgemäß verwendeten Vermittlerschichten auch auf zwei separaten adaptiven Spiegeln vorhanden sein, wobei dann jeder dieser Vermittlerschichten insoweit analog zu Fig. 5 eine strukturierte Elektrodenanordnung und eine als flächige Elektrode ausgelegte Elektrodenanordnung zugeordnet sein kann. In diesem Falle wird vorzugsweise derjenige adaptive Spiegel mit der vergleichsweise niederohmigen Vermittlerschicht (zur schnellen Einstellung vergleichsweise geringer Deformationsamplituden z.B. zur Korrektur einer thermisch induzierten Maskendeformation) in einer feldnahen Ebene des optischen Systems platziert, wohingegen der andere adaptive Spiegel mit vergleichsweise höherohmiger Vermittlerschicht (zur vergleichsweise langsamen Einstellung von größeren Deformationsamplituden z.B. zur Korrektur thermisch induzierter Spiegeldeformationen) in einer pupillennahen Position platziert wird.

Gemäß einem weiteren Aspekt betrifft die Erfindung daher auch ein optisches System, insbesondere Beleuchtungseinrichtung oder Projektionsobjektiv einer mikrolithographischen Projektionsbelichtungsanlage, mit wenigstens zwei Spiegeln, wobei jeder dieser Spiegel eine optische Wirkfläche, ein Spiegelsubstrat und einen Reflexionsschichtstapel zur Reflexion von auf die optische Wirkfläche auftreffender elektromagnetischer Strahlung aufweist,
- wobei jeder dieser Spiegel eine piezoelektrische Schicht aufweist, welche jeweils zwischen Spiegelsubstrat und Reflexionsschichtstapel angeordnet und über eine erste, auf der dem Reflexionsschichtstapel zugewandten Seite der piezoelektrischen Schicht befindliche Elektrodenanordnung und eine zweite, auf der dem Spiegelsubstrat zugewandten Seite der piezoelektrischen Schicht befindliche Elektrodenanordnung mit einem elektrischen Feld zur Erzeugung einer lokal variablen Deformation beaufschlagbar ist,
- wobei jeder dieser Spiegel jeweils eine Vermittlerschicht zur Einstellung eines kontinuierlichen Verlaufs des elektrischen Potentials aufweist, und
- wobei sich diese Vermittlerschichten in ihrem mittleren elektrischen Widerstand um einen Faktor von wenigstens 1.5 voneinander unterscheiden.

Die Erfindung betrifft weiter ein optisches System einer mikrolithographischen Projektionsbelichtungsanlage, insbesondere eine Beleuchtungseinrichtung oder ein Projektionsobjektiv, mit wenigstens einem Spiegel mit den vorstehend beschriebenen Merkmalen, sowie auch eine mikrolithographische Projektionsbelichtungsanlage.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1: eine schematische Darstellung zur Erläuterung des Aufbaus eines adaptiven Spiegels gemäß einer Ausführungsform der Erfindung;
- Figur 2-3: schematische Darstellungen zur Erläuterung des Aufbaus eines adaptiven Spiegels gemäß weiterer Ausführungsformen der Erfindung;
- Figur 4: eine schematische Darstellung zur Erläuterung des möglichen Aufbaus einer für den Betrieb im EUV ausgelegten mikrolithographischen Projektionsbelichtungsanlage;
- Figur 5: eine schematische Darstellung zur Erläuterung des möglichen Aufbaus eines herkömmlichen adaptiven Spiegels; und
- Figur 6: ein Diagramm zur Erläuterung des Einflusses einer Vermittlerschicht in einem herkömmlichen adaptiven Spiegel gemäß Figur 5.

### DETAILLIERTE BESCHREIBUNG BEVORZUGTER AUSFÜHRUNGSFORMEN

Fig. 1 zeigt eine schematische Darstellung zur Erläuterung des Aufbaus eines erfindungsgemäßen Spiegels in einer beispielhaften Ausführungsform der Erfindung. Der Spiegel 10 umfasst insbesondere ein Spiegelsubstrat 12, welches aus einem beliebigen geeigneten Spiegelsubstratmaterial hergestellt ist. Geeignete Spiegelsubstratmaterialien sind z.B. Titandioxid (TiO₂)-dotiertes Quarzglas, wobei lediglich beispielhaft (und ohne dass die Erfindung hierauf beschränkt wäre) die unter den Markenbezeichnungen ULE^{®} (der Firma Corning Inc.) oder Zerodur^{®} (der Firma Schott AG) vertriebenen Materialien verwendbar sind.

Des Weiteren weist der Spiegel 10 in grundsätzlich für sich bekannter Weise einen Reflexionsschichtstapel 21 auf, welcher in der dargestellten Ausführungsform lediglich beispielhaft einen Molybdän-Silizium (Mo-Si)-Schichtstapel umfasst. Ohne dass die Erfindung auf konkrete Ausgestaltungen dieses Schichtstapels beschränkt wäre, kann ein lediglich beispielhafter geeigneter Aufbau etwa 50 Lagen bzw. Schichtpakete eines Schichtsystems aus Molybdän (Mo)-Schichten mit einer Schichtdicke von jeweils 2.4nm und Silizium (Si)-Schichten mit einer Schichtdicke von jeweils 3.3nm umfassen.

Bei dem Spiegel 10 kann es sich insbesondere um einen EUV-Spiegel eines optischen Systems, insbesondere des Projektionsobjektivs oder der Beleuchtungseinrichtung einer mikrolithographischen Projektionsbelichtungsanlage, handeln.

Die im Betrieb des optischen Systems erfolgende Beaufschlagung der optischen Wirkfläche 11 des Spiegels 10 mit elektromagnetischer EUV-Strahlung (in Fig. 1 durch einen Pfeil angedeutet) kann eine inhomogene Volumenänderung des Spiegelsubstrats 12 aufgrund der Temperaturverteilung zur Folge haben, die aus der Absorption von inhomogen auf die optische Wirkfläche 11 auftreffender Strahlung resultiert. Zur Korrektur einer solchen unerwünschten Volumenänderung oder auch zur Korrektur anderweitiger, im Betrieb der mikrolithographischen Projektionsbelichtungsanlage auftretender Aberrationen ist der Spiegel 10 adaptiv ausgelegt, wie im Weiteren näher erläutert wird. Hierzu weist der erfindungsgemäße Spiegel 10 eine piezoelektrische Schicht 16 auf, welche im Ausführungsbeispiel aus Blei-Zirkonat-Titanat (Pb(Zr,Ti)O₃, PZT) hergestellt ist. In weiteren Ausführungsformen kann die piezoelektrische Schicht 16 auch aus einem anderen geeigneten Material (z.B. Aluminium-Nitrid (AIN), Aluminium-Scandium-Nitrid (AIScN), Blei-Magnesium-Niobat (PbMgNb) oder Vanadium-dotiertem Zinkoxid (ZnO)) hergestellt sein kann. Die piezoelektrische Schicht 16 kann beispielsweise eine Dicke von weniger als 5µm, weiter insbesondere eine Dicke im Bereich von 1µm bis 4µm aufweisen. In Ausführungsformen kann die Performanz der piezoelektrischen Schicht 16 durch Einführung einer Kalzium-Niobat-Schicht (CaNbO₃-Schicht) an geeigneter Stelle des Schichtstapels gesteigert werden. Die Steigerung der Performanz wird hierbei dadurch erreicht, dass die piezoelektrische Schicht 16 vorzugsweise in [001]-Kristallrichtung aufwächst.

Die piezoelektrische Schicht 16 ist über eine erste, auf der dem Reflexionsschichtstapel 21 zugewandten Seite der piezoelektrischen Schicht 16 befindliche Elektrodenanordnung mit Elektroden 20b (welche an Zuleitungen 19b angeschlossen sind) und eine zweite, auf der dem Spiegelsubstrat 12 zugewandten Seite der piezoelektrischen Schicht 16 befindliche Elektrodenanordnung mit Elektroden 20a (welche an Zuleitungen 19a angeschlossen sind) mit einem elektrischen Feld zur Erzeugung einer lokal variablen Deformation beaufschlagbar.

Die Elektroden 20a bzw. 20b sind jeweils in eine Glättschicht 18a bzw. 18b eingebettet, welche im Ausführungsbeispiel aus Quarz (SiO₂) hergestellt ist und zur Einebnung der aus den Elektroden 20a bzw. 20b gebildeten Elektrodenanordnung dient. Des Weiteren weisen die Elektroden 20a bzw. 20b - ohne dass die Erfindung hierauf beschränkt wäre - eine hexagonale Geometrie auf, wobei sie insbesondere auch weitgehend flächendeckend und nur über vergleichsweise schmale Gräben voneinander isoliert angeordnet sein können. Die Erfindung ist generell nicht auf bestimmte Geometrien oder Abstände der Elektroden beschränkt (wobei der Abstand zwischen den Elektroden auch z.B. mehrere Millimeter (mm) oder mehrere Zentimeter (cm) betragen kann).

Die Zuleitungen 19a bzw. 19b weisen gemäß Fig. 1 jeweils einen ersten, senkrecht zur Stapelrichtung des Reflexionsschichtstapels 21 verlaufenden Abschnitt und einen zweiten, in Stapelrichtung des Reflexionsschichtstapels 21 verlaufenden Abschnitt (auch als "Via" oder "Durchkontaktierung" bezeichnet) auf. Auch andere Arten der Kontaktierung sind möglich, wobei z.B. die Zuleitungen in weiteren Ausführungsformen auch mit lediglich einem senkrecht zur Stapelrichtung verlaufenden Abschnitt (in zweidimensionaler Auslegung und ohne "Vias") realisiert werden können.

Des Weiteren weist der Spiegel 10 gemäß Fig. 1 zwischen dem Spiegelsubstrat 12 und der aus den Elektroden 20a gebildeten, dem Spiegelsubstrat 12 zugewandten unteren Elektrodenanordnung eine optionale Haftschicht 13 (im Beispiel aus Titan, Ti) auf. Ferner sind mit "15a" bzw. "15b" auf beiden Seiten der piezoelektrischen Schicht 16 vorhandene Pufferschichten bezeichnet. Diese Pufferschichten 15a, 15b dienen dazu, das Aufwachsen von PZT in optimaler, kristalliner Struktur weiter zu unterstützen und gleichbleibende Polarisationseigenschaften der piezoelektrischen Schicht 16 über die Lebensdauer sicherzustellen, und können z.B. aus LaNiO₃ hergestellt sein.

Im Betrieb des Spiegels 10 bzw. eines diesen Spiegel 10 aufweisenden optischen Systems führt das Anlegen einer elektrischen Spannung an die aus den Elektroden 20a bzw. 20b gebildeten Elektrodenanordnungen über das sich im Bereich der piezoelektrischen Schicht 16 ausbildende elektrische Feld zu einer Auslenkung dieser piezoelektrischen Schicht 16. Auf diese Weise kann zur Kompensation von optischen Aberrationen eine Aktuierung des Spiegels 10 erzielt werden.

Im Unterschied zu dem eingangs anhand von Fig. 5 beschriebenen herkömmlichen Aufbau eines adaptiven Spiegels sind bei dem erfindungsgemäßen Spiegel 10 gemäß Fig. 1 den auf einander gegenüberliegenden Seiten der piezoelektrischen Schicht 16 befindlichen Elektrodenanordnungen jeweils separate Vermittlerschichten 17a bzw. 17b zur Einstellung eines kontinuierlichen Verlaufs des elektrischen Potentials entlang der jeweiligen Elektrodenanordnung zugeordnet.

In dieser Anordnung können dann beide Vermittlerschichten 17a bzw. 17bfalls sie aus LaNiO₃ hergestellt sind - auch als Pufferschichten für das PZT der piezoelektrischen Schicht 16 dienen, in welchem Falle dann separate Pufferschichten 15a, 15b entfallen können. Ist hingegen die Vermittlerschicht aus einem anderen Material als LaNiO₃ hergestellt, werden wie dargestellt Pufferschichten 15a, 15b auf beiden Seiten des PZTs der piezoelektrischen Schicht 16 vorgesehen.

Des Weiteren ist im Unterschied zur herkömmlichen Anordnung von Fig. 5 nicht etwa eine der beiden Elektrodenanordnungen als flächige durchgehende Elektrode ausgebildet, sondern beide auf einander gegenüberliegenden Seiten der piezoelektrischen Schicht 16 befindlichen Elektrodenanordnungen umfassen jeweils über separate Zuleitungen mit elektrischer Spannung beaufschlagbare Elektroden 20a, 20b.

Die Vermittlerschichten 17a und 17b sind nicht identisch zueinander ausgebildet, sondern unterscheiden sich hinsichtlich ihres mittleren elektrischen Widerstandes um einen Faktor von wenigstens 1.5 (in weiteren Ausführungsformen um einen Faktor von wenigstens 3, insbesondere um einen Faktor von wenigstens 5) voneinander. Hierzu können die Vermittlerschichten 17a, 17b voneinander verschiedene Stöchiometrien und/oder voneinander verschiedene mittlere Dicken besitzen. Verschiedene Stöchiometrien können z.B. über unterschiedliche Partialdrücke, unterschiedliche Hintergrunddrücke oder unterschiedliche Temperaturen bei der Deposition erreicht werden. Die Verwendung unterschiedlicher Materialien für die Vermittlerschicht ist ebenfalls möglich.

Die unterschiedliche Ausgestaltung der Vermittlerschichten 17a, 17b hinsichtlich ihres jeweiligen elektrischen Widerstandes hat zur Folge, dass die vergleichsweise niederohmige Vermittlerschicht eine vergleichsweise schnellere bzw. auf kürzerer Zeitskala erfolgende "Umschaltung" des jeweiligen elektrischen Potentials im Betrieb des Spiegels 10 bzw. des zugehörigen optischen Systems ermöglicht, wohingegen die vergleichsweise höherohmige Vermittlerschicht aufgrund der reziproken Abhängigkeit der generierten elektrischen Leistung vom elektrischen Widerstand vergleichsweise geringe thermische Lasten im Betrieb des Spiegels 10 bzw. des betreffenden optischen Systems zur Folge hat.

Diese unterschiedlichen charakteristischen Eigenschaften können wiederum wie bereits vorstehend beschrieben dahingehend ausgenutzt werden, dass die Spannungsbeaufschlagung zwecks lokal variabler Deformation der piezoelektrischen Schicht 16 in Szenarien, in denen vergleichsweise geringe Deformationsamplituden auf vergleichsweise kurzer Zeitskala einzustellen sind, die der Vermittlerschicht mit dem relativ geringeren mittleren elektrischen Widerstand zugeordnete Elektrodenanordnung genutzt wird. Ein solches beispielhaftes Szenario ist insbesondere die Kompensation thermische induzierter Maskendeformationen im Lithographiebetrieb. Hingegen wird zur Einstellung vergleichsweise größerer Deformationsamplituden auf größerer Zeitskala die der Vermittlerschicht mit dem relativ höheren elektrischen Widerstand zugeordnete Elektrodenanordnung verwendet. Ein beispielhaftes Szenario hierfür ist die Kompensation thermisch induzierter Spiegeldeformationen bzw. hierdurch hervorgerufener Aberrationen im optischen System.

In einem konkreten Ausführungsbeispiel kann etwa die Vermittlerschicht 17b einen mittleren elektrischen Widerstand von 100kΩ aufweisen und mit elektrischen Spannungen im Bereich von 100V angesteuert werden, um Umschaltungen zwischen Deformationsamplituden von größenordnungsmäßig 10nm auf einer Zeitskala von 10s zu ermöglichen, wobei hierdurch bereitgestellte Deformationen des adaptiven Spiegels zur Kompensation der vorstehend beschriebenen thermisch induzierten Spiegeldeformationen im optischen System geeignet sind.

Hingegen kann die Vermittlerschicht 17a lediglich beispielhaft einen mittleren elektrischen Widerstand von 1kΩ besitzen und mit elektrischen Spannungen von ca. 10V-Amplitude angesteuert werden, um zwischen Deformationsamplituden von größenordnungsmäßig 1nm in ca. 100ms umzuschalten, wobei hierdurch bewirkte Deformationen des adaptiven Spiegels 10 zur Kompensation der ebenfalls vorstehend beschriebenen thermisch induzierten Maskendeformationen im Lithographiebetrieb geeignet sind.

In einer weiteren (nicht dargestellten) Ausführungsform können die vorstehend beschriebenen separaten und hinsichtlich ihres mittleren elektrischen Widerstandes voneinander verschiedenen Vermittlerschichten auch in unterschiedlichen separaten Spiegeln realisiert sein, um den o.g. Einsatzszenarien jeweils gezielt Rechnung zu tragen bzw. die vorstehend beschriebene Aufgabenteilung hinsichtlich der Kompensation unterschiedlicher Aberrationen im Betrieb des optischen Systems zu realisieren. Hierzu wird vorzugsweise der die vergleichsweise niederohmige Vermittlerschicht aufweisende adaptive Spiegel zur Kompensation thermisch induzierter Maskendeformationen in einer feldnahen Ebene und der andere, die vergleichsweise höherohmige Vermittlerschicht aufweisende adaptive Spiegel zur Kompensation thermisch induzierter Spiegeldeformationen in einer pupillennahen Ebene platziert.

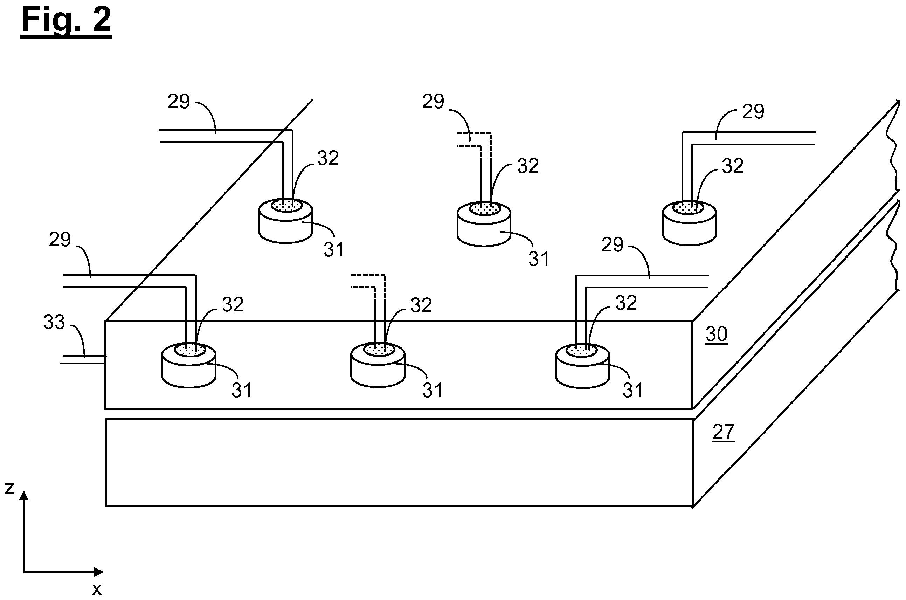

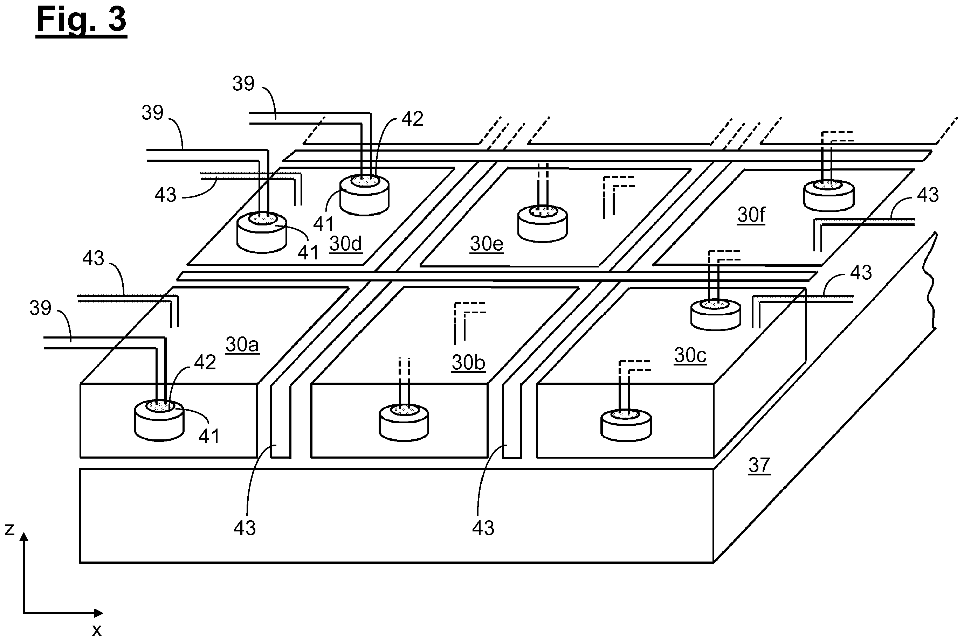

In weiteren, im Folgenden unter Bezugnahme auf Fig. 2 und Fig. 3 beschriebenen Ausführungsformen kann die Vermittlerschicht in einem erfindungsgemäßen adaptiven Spiegel auch so ausgelegt sein, dass die elektrische Leitfähigkeit der Vermittlerschicht im Betrieb steuerbar ist bzw. zeitlich variabel eingestellt werden kann.

In einem in Fig. 2 lediglich schematisch dargestellten Ausführungsbeispiel ist mit "27" eine Vermittlerschicht mit FET-Struktur bezeichnet, welche z.B. aus dotiertem Halbleitermaterial hergestellt sein kann und deren elektrische Leitfähigkeit über eine durchgängig ausgestaltete (über eine Zuleitung 33 mit einem elektrischem Feld beaufschlagbare) Steuerelektrode 30 gesteuert wird. Mit "32" sind in Fig. 2 die zur Steuerung der Auslenkung der (in Fig. 2 nicht dargestellten) piezoelektrischen Schicht dienenden Elektroden bezeichnet, wobei diese Elektroden 32 über Isolatoren 31 von der Steuerelektrode 30 elektrisch isoliert sind.

Über die in Fig. 2 dargestellte Ausgestaltung kann die elektrische Spannung der Vermittlerschicht 27 zeitlich variabel eingestellt werden. Dabei kann eine vergleichsweise größere elektrische Leitfähigkeit bzw. ein geringerer mittlerer elektrischer Widerstand analog zu der zuvor anhand von Fig. 1 beschriebenen Ausführungsform zur Einstellung von vergleichsweise geringeren Deformationsamplituden auf kürzerer Zeitskala dienen, wohingegen die elektrische Leitfähigkeit zur Einstellung vergleichsweise höherer Deformationsamplituden auf größerer Zeitskala dann entsprechend herabgesetzt werden kann.

In einem beispielhaften Betrieb der Anordnung von Fig. 2 kann in einem ersten Schritt eine maximal zulässige Wärmeentwicklung vorgegeben werden, wobei ausgehend vom jeweils gewünschten bzw. anzusteuernden Deformationsprofil dann in einem zweiten Schritt die FET-Steuerspannung so gewählt wird, dass gerade diejenige maximale Leitfähigkeit der Vermittlerschicht entsteht, welche zu dieser maximalen Wärmeentwicklung führt. Auf diese Weise kann zu jedem Zeitpunkt eine maximale Geschwindigkeit hinsichtlich der Einstellung des jeweils gewünschten elektrischen Potentials erzielt werden. Die maximale Wärmeentwicklung kann hierbei entweder über einen globalen Wert oder einen lokalen Spitzenwert charakterisiert werden. Ist die erreichte Einstellgeschwindigkeit hinsichtlich des angestrebten Deformationsmusters bzw. elektrischen Potentials kleiner als erwünscht, kann alternativ die Deformationsamplitude derart "herunterskaliert" werden, dass sowohl die gewünschte Einstellgeschwindigkeit als auch die maximale Wärmeentwicklung erreicht werden. Alternativ oder zusätzlich kann auch eine Rückmeldung an eine externe Regelungseinheit erfolgen, über welche ein geeigneter Kompromiss zur Gewährleistung der bestmöglichen Korrektur unter Berücksichtigung der Anforderungen hinsichtlich Einstellgeschwindigkeit und Wärmeentwicklung gewährleistet wird.

Fig. 3 zeigt eine weitere Ausführungsform, wobei zu Fig. 2 analoge bzw. im Wesentlichen funktionsgleiche Komponenten mit um "10" erhöhten Bezugsziffern bezeichnet sind. Im Unterschied zu Fig. 2 sind bei der Ausführungsform von Fig. 3 separate (über Zuleitungen 43 mit einem elektrischem Feld beaufschlagbare) Steuerelektroden 30a, 30b, 30c ... zur Steuerung der Leitfähigkeit der Vermittlerschicht 37 voneinander elektrisch isoliert vorgesehen, wobei sich wiederum analog zu Fig. 2 vorhandene Elektroden 42 zur Steuerung der Auslenkung der piezoelektrischen Schicht über Isolatoren 41 eigenständig isoliert innerhalb dieser Elektrodenabschnitte 30a, 30b, 30c ... befinden. Durch die gemäß Fig. 3 realisierbare Einstellung lokal unterschiedlicher Werte für die FET-Steuerspannung kann die Flexibilität der Anordnung weiter gesteigert werden. Auf diese Weise kann beispielsweise zu einem vorgegebenen Zeitpunkt eine gewünschte schnelle Einstellung eines bestimmten Deformationsmusters auf einen zentralen Bereich des adaptiven Spiegels beschränkt werden, wohingegen z.B. in einem radial äußeren Bereich des Spiegels relativ größere Deformationsamplituden auf größerer Zeitskala bzw. mit geringerer Einstellgeschwindigkeit realisiert werden können. Hierzu können z.B. radial weiter innen angeordnete Steuerelektroden 30a, 30b, 30c ... eine vergleichsweise höhere elektrische Leitfähigkeit der Vermittlerschicht 37 einstellen, während über radial weiter außen angeordnete Steuerelektroden eine vergleichsweise geringere elektrische Leitfähigkeit vorgegeben werden kann.

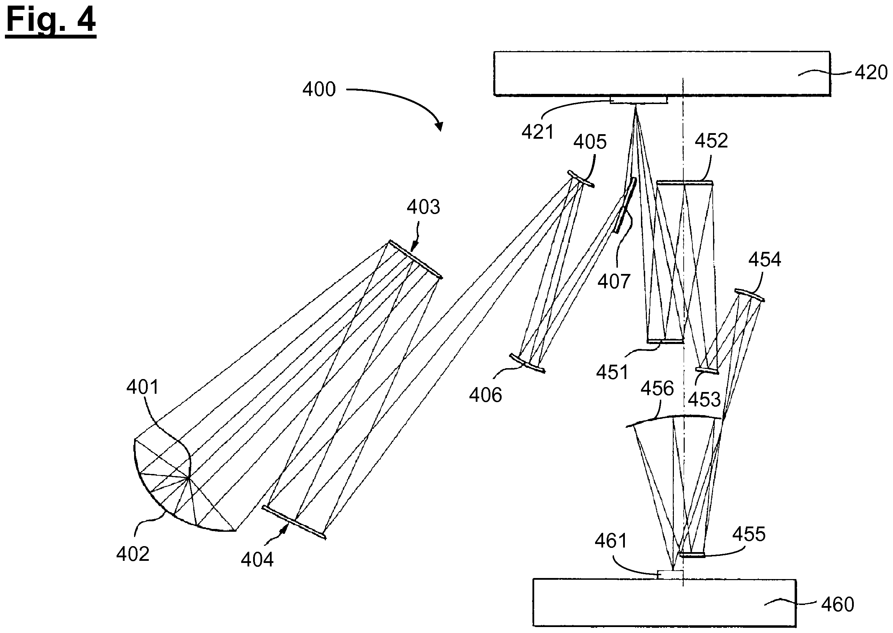

Fig. 4 zeigt eine schematische Darstellung einer beispielhaften für den Betrieb im EUV ausgelegten Projektionsbelichtungsanlage, in welcher die vorliegende Erfindung realisierbar ist.

Gemäß Fig. 4 weist eine Beleuchtungseinrichtung in einer für EUV ausgelegten Projektionsbelichtungsanlage 400 einen Feldfacettenspiegel 403 und einen Pupillenfacettenspiegel 404 auf. Auf den Feldfacettenspiegel 403 wird das Licht einer Lichtquelleneinheit, welche eine Plasmalichtquelle 401 und einen Kollektorspiegel 402 umfasst, gelenkt. Im Lichtweg nach dem Pupillenfacettenspiegel 404 sind ein erster Teleskopspiegel 405 und ein zweiter Teleskopspiegel 406 angeordnet. Im Lichtweg nachfolgend ist ein Umlenkspiegel 407 angeordnet, der die auf ihn treffende Strahlung auf ein Objektfeld in der Objektebene eines sechs Spiegel 451-456 umfassenden Projektionsobjektivs lenkt. Am Ort des Objektfeldes ist eine reflektive strukturtragende Maske 421 auf einem Maskentisch 420 angeordnet, die mit Hilfe des Projektionsobjektivs in eine Bildebene abgebildet wird, in welcher sich ein mit einer lichtempfindlichen Schicht (Photoresist) beschichtetes Substrat 461 auf einem Wafertisch 460 befindet.

Von den Spiegeln 451-456 des Projektionsobjektivs können lediglich beispielhaft die - bezogen auf den optischen Strahlengang im Anfangsbereich des Projektionsobjektivs angeordneten - Spiegel 451 und 452 in der erfindungsgemäßen Weise ausgestaltet sein, da der erzielte Effekt einer Kompensation thermischer Deformationen infolge der an diesen Spiegeln 451, 452 aufgrund der noch vergleichsweise geringen aufsummierten Reflexionsverluste und damit der relativ hohen Lichtintensitäten dann besonders ausgeprägt ist. Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche beschränkt ist.

## Patentansprüche

1. Spiegel, insbesondere für eine mikrolithographische Projektionsbelichtungsanlage, wobei der Spiegel eine optische Wirkfläche (11) aufweist, mit
• einem Spiegelsubstrat (12);
• einem Reflexionsschichtstapel (21) zur Reflexion von auf die optische Wirkfläche (11) auftreffender elektromagnetischer Strahlung; und
• wenigstens einer piezoelektrischen Schicht (16), welche zwischen Spiegelsubstrat (12) und Reflexionsschichtstapel (21) angeordnet und über eine erste, auf der dem Reflexionsschichtstapel (21) zugewandten Seite der piezoelektrischen Schicht (16) befindliche Elektrodenanordnung und eine zweite, auf der dem Spiegelsubstrat (12) zugewandten Seite der piezoelektrischen Schicht (16) befindliche Elektrodenanordnung mit einem elektrischen Feld zur Erzeugung einer lokal variablen Deformation beaufschlagbar ist;
• wobei sowohl die erste Elektrodenanordnung als auch die zweite Elektrodenanordnung eine Mehrzahl von Elektroden (20a, 20b) aufweist, welche jeweils über eine Zuleitung (19a, 19b) mit einer elektrischen Spannung bezogen auf die jeweils andere Elektrodenanordnung beaufschlagbar sind;
• wobei jeder dieser Elektrodenanordnungen jeweils eine separate Vermittlerschicht (17a, 17b) zur Einstellung eines kontinuierlichen Verlaufs des elektrischen Potentials entlang der jeweiligen Elektrodenanordnung zugeordnet ist; und
• wobei sich diese Vermittlerschichten (17a, 17b) in ihrem mittleren elektrischen Widerstand um einen Faktor von wenigstens 1.5 voneinander unterscheiden.

2. Spiegel nach Anspruch 1, **dadurch gekennzeichnet, dass** sich die Vermittlerschichten (17a, 17b) in ihrem mittleren elektrischen Widerstand um einen Faktor von wenigstens 3, insbesondere um einen Faktor von wenigstens 5, voneinander unterscheiden.

3. Spiegel nach Anspruch 1 oder 2, **dadurch gekennzeichnet, dass** sich die Vermittlerschichten (17a, 17b) in ihrer mittleren Dicke voneinander unterscheiden.

4. Spiegel nach einem der Ansprüche 1 bis 3, **dadurch gekennzeichnet, dass** sich die Vermittlerschichten (17a, 17b) hinsichtlich ihrer Stöchiometrie voneinander unterscheiden.

5. Spiegel nach einem der vorhergehenden Ansprüche, **dadurch gekennzeichnet, dass** das Material wenigstens einer der Vermittlerschichten (17a, 17b) Titandioxid (TiO₂), LaCoO₃, LaMnO₃, LaCaMnO₃ oder LaNiO₃ aufweist.

6. Spiegel, insbesondere für eine mikrolithographische Projektionsbelichtungsanlage, wobei der Spiegel eine optische Wirkfläche aufweist, mit
• einem Spiegelsubstrat;
• einem Reflexionsschichtstapel zur Reflexion von auf die optische Wirkfläche auftreffender elektromagnetischer Strahlung; und
• wenigstens einer piezoelektrischen Schicht, welche zwischen Spiegelsubstrat und Reflexionsschichtstapel angeordnet und über eine erste, auf der dem Reflexionsschichtstapel zugewandten Seite der piezoelektrischen Schicht befindliche Elektrodenanordnung und eine zweite, auf der dem Spiegelsubstrat zugewandten Seite der piezoelektrischen Schicht befindliche Elektrodenanordnung mit einem elektrischen Feld zur Erzeugung einer lokal variablen Deformation beaufschlagbar ist;
• wobei wenigstens einer dieser Elektrodenanordnungen eine Vermittlerschicht (27, 37) mit steuerbarer elektrischer Leitfähigkeit zur zeitlich variablen Einstellung eines kontinuierlichen Verlaufs des elektrischen Potentials entlang der jeweiligen Elektrodenanordnung zugeordnet ist.

7. Spiegel nach Anspruch 6, **dadurch gekennzeichnet, dass** dieser wenigstens eine Steuerelektrode (30, 30a, 30b, 30c,...), insbesondere eine Mehrzahl von unabhängig voneinander betreibbaren Steuerelektroden (30a, 30b, 30c,...), zur Steuerung der elektrischen Leitfähigkeit der Vermittlerschicht (27, 37) aufweist.

8. Spiegel nach einem der vorhergehenden Ansprüche, **dadurch gekennzeichnet, dass** der Spiegel für eine Arbeitswellenlänge von weniger als 30 nm, insbesondere weniger als 15 nm, ausgelegt ist.

9. Spiegel nach einem der vorhergehenden Ansprüche, **dadurch gekennzeichnet, dass** dieser ein Spiegel für eine mikrolithographische Projektionsbelichtungsanlage ist.

10. Optisches System, insbesondere Beleuchtungseinrichtung oder Projektionsobjektiv einer mikrolithographischen Projektionsbelichtungsanlage, **dadurch gekennzeichnet, dass** das optische System einen Spiegel nach einem der vorhergehenden Ansprüche aufweist.

11. Optisches System, insbesondere Beleuchtungseinrichtung oder Projektionsobjektiv einer mikrolithographischen Projektionsbelichtungsanlage, mit wenigstens zwei Spiegeln, wobei jeder dieser Spiegel eine optische Wirkfläche, ein Spiegelsubstrat und einen Reflexionsschichtstapel zur Reflexion von auf die optische Wirkfläche auftreffender elektromagnetischer Strahlung aufweist;
• wobei jeder dieser Spiegel eine piezoelektrische Schicht aufweist, welche jeweils zwischen Spiegelsubstrat und Reflexionsschichtstapel angeordnet und über eine erste, auf der dem Reflexionsschichtstapel zugewandten Seite der piezoelektrischen Schicht befindliche Elektrodenanordnung und eine zweite, auf der dem Spiegelsubstrat zugewandten Seite der piezoelektrischen Schicht befindliche Elektrodenanordnung mit einem elektrischen Feld zur Erzeugung einer lokal variablen Deformation beaufschlagbar ist;
• wobei jeder dieser Spiegel jeweils eine Vermittlerschicht zur Einstellung eines kontinuierlichen Verlaufs des elektrischen Potentials aufweist; und
• wobei sich diese Vermittlerschichten in ihrem mittleren elektrischen Widerstand um einen Faktor von wenigstens 1.5 voneinander unterscheiden.

12. Optisches System nach Anspruch 11, **dadurch gekennzeichnet, dass** sich diese Vermittlerschichten in ihrem mittleren elektrischen Widerstand um einen Faktor von wenigstens 3, insbesondere um einen Faktor von wenigstens 5, voneinander unterscheiden.

13. Mikrolithographische Projektionsbelichtungsanlage (400) mit einer Beleuchtungseinrichtung und einem Projektionsobjektiv, **dadurch gekennzeichnet, dass** die Projektionsbelichtungsanlage ein optisches System nach einem der Ansprüche 11 bis 12 aufweist.

## Claims

1. Mirror, in particular for a microlithographic projection exposure apparatus, wherein the mirror has an optical effective surface (11), comprising
• a mirror substrate (12);
• a reflection layer stack (21) for reflecting electromagnetic radiation that is incident on the optical effective surface (11); and
• at least one piezoelectric layer (16), which is arranged between the mirror substrate (12) and the reflection layer stack (21) and to which an electric field for producing a locally variable deformation is able to be applied by way of a first electrode arrangement situated on the side of the piezoelectric layer (16) facing the reflection layer stack (21), and by way of a second electrode arrangement situated on the side of the piezoelectric layer (16) facing the mirror substrate (12) ;
• wherein both the first electrode arrangement and the second electrode arrangement have a plurality of electrodes (20a, 20b), to each of which an electrical voltage relative to the respective other electrode arrangement is able to be applied by way of a lead (19a, 19b) ;
• wherein each of said electrode arrangements is respectively assigned a separate mediator layer (17a, 17b) for setting a continuous profile of the electrical potential along the respective electrode arrangement; and
• wherein said mediator layers (17a, 17b) differ from one another in their average electrical resistance by a factor of at least 1.5.

2. Mirror according to Claim 1, **characterized in that** the mediator layers (17a, 17b) differ from one another in their average electrical resistance by a factor of at least 3, in particular by a factor of at least 5.

3. Mirror according to Claim 1 or 2, **characterized in that** the mediator layers (17a, 17b) differ from one another in their average thickness.

4. Mirror according to any of Claims 1 to 3, **characterized in that** the mediator layers (17a, 17b) differ from one another with regard to their stoichiometry.

5. Mirror according to any of the preceding claims, **characterized in that** the material of at least one of the mediator layers (17a, 17b) comprises titanium dioxide (TiO₂), LaCoO₃, LaMnO₃, LaCaMnO₃ or LaNiO₃.

6. Mirror, in particular for a microlithographic projection exposure apparatus, wherein the mirror has an optical effective surface, comprising
• a mirror substrate;
• a reflection layer stack for reflecting electromagnetic radiation that is incident on the optical effective surface; and
• at least one piezoelectric layer, which is arranged between the mirror substrate and the reflection layer stack and to which an electric field for producing a locally variable deformation is able to be applied by way of a first electrode arrangement situated on the side of the piezoelectric layer facing the reflection layer stack, and by way of a second electrode arrangement situated on the side of the piezoelectric layer facing the mirror substrate;
• wherein at least one of said electrode arrangements is assigned a mediator layer (27, 37) having a controllable electrical conductivity for the temporally variable setting of a continuous profile of the electrical potential along the respective electrode arrangement.

7. Mirror according to Claim 6, **characterized in that** it has at least one control electrode (30, 30a, 30b, 30c,...), in particular a plurality of mutually independently operable control electrodes (30a, 30b, 30c,...), for controlling the electrical conductivity of the mediator layer (27, 37).

8. Mirror according to any of the preceding claims, **characterized in that** the mirror is designed for an operating wavelength of less than 30 nm, in particular less than 15 nm.

9. Mirror according to any of the preceding claims, **characterized in that** said mirror is a mirror for a microlithographic projection exposure apparatus.

10. Optical system, in particular illumination device or projection lens of a microlithographic projection exposure apparatus, **characterized in that** the optical system has a mirror according to any of the preceding claims.

11. Optical system, in particular illumination device or projection lens of a microlithographic projection exposure apparatus, comprising at least two mirrors, wherein each of said mirrors has an optical effective surface, a mirror substrate and a reflection layer stack for reflecting electromagnetic radiation that is incident on the optical effective surface;
• wherein each of said mirrors has a piezoelectric layer, which is arranged in each case between the mirror substrate and the reflection layer stack and to which an electric field for producing a locally variable deformation is able to be applied by way of a first electrode arrangement situated on the side of the piezoelectric layer facing the reflection layer stack, and by way of a second electrode arrangement situated on the side of the piezoelectric layer facing the mirror substrate;
• wherein each of said mirrors has in each case a mediator layer for setting a continuous profile of the electrical potential; and
• wherein said mediator layers differ from one another in their average electrical resistance by a factor of at least 1.5.

12. Optical system according to Claim 11, **characterized in that** said mediator layers differ from one another in their average electrical resistance by a factor of at least 3, in particular by a factor of at least 5.

13. Microlithographic projection exposure apparatus (400) comprising an illumination device and a projection lens, **characterized in that** the projection exposure apparatus has an optical system according to either of Claims 11 and 12.

## Revendications

1. Miroir, destiné notamment à une installation d'exposition par projection microlithographique, le miroir ayant une surface optique active (11), ledit miroir comprenant
• un substrat de miroir (12) ;
• un empilement de couches réfléchissantes (21) destiné à réfléchir le rayonnement électromagnétique incident à la surface optique active (11) ; et
• au moins une couche piézoélectrique (16), qui est disposée entre le substrat de miroir (12) et l'empilement de couches réfléchissantes (21) et qui peut être soumise à un champ électrique pour générer une déformation localement variable par le biais d'un premier ensemble d'électrodes se trouvant du côté de la couche piézoélectrique (16) qui est dirigé vers l'empilement de couches réfléchissantes (21) et d'un deuxième ensemble d'électrodes se trouvant du côté de la couche piézoélectrique (16) qui est dirigé vers le substrat de miroir (12) ;
• le premier ensemble d'électrodes ainsi que le deuxième ensemble d'électrodes comportant une pluralité d'électrodes (20a, 20b) qui peuvent chacune être soumises à une tension électrique par rapport à l'autre ensemble d'électrodes par le biais d'une ligne d'alimentation (19a, 19b) ;
• chacun de ces ensembles d'électrodes étant associé à une couche médiatrice séparée (17a, 17b) pour établir une évolution continue du potentiel électrique le long de l'ensemble d'électrodes respectif ; et
• ces couches médiatrices (17a, 17b) différant les unes des autres par leur résistance électrique moyenne d'un facteur d'au moins 1,5.

2. Miroir selon la revendication 1, **caractérisé en ce que** les couches médiatrices (17a, 17b) diffèrent les unes des autres par leur résistance électrique moyenne d'un facteur d'au moins 3, notamment d'un facteur d'au moins 5.

3. Miroir selon la revendication 1 ou 2, **caractérisé en ce que** les couches médiatrices (17a, 17b) diffèrent les unes des autres par leur épaisseur moyenne.

4. Miroir selon l'une des revendications 1 à 3, **caractérisé en ce que** les couches médiatrices (17a, 17b) diffèrent les unes des autres par leur stœchiométrie.

5. Miroir selon l'une des revendications précédentes, **caractérisé en ce que** le matériau d'au moins une des couches médiatrices (17a, 17b) comprend du dioxyde de titane (TiO₂), du LaCoO₃, du LaMnO₃, du LaCaMnO₃ ou du LaNiO₃.

6. Miroir, destiné notamment à un système d'exposition par projection microlithographique, le miroir ayant une surface optique active, ledit miroir comprenant
• un substrat de miroir ;
• un empilement de couches réfléchissantes destiné à réfléchir le rayonnement électromagnétique incident à la surface optique active ; et
• au moins une couche piézoélectrique, qui est disposée entre le substrat de miroir et l'empilement de couches réfléchissantes et qui peut être soumise à un champ électrique pour générer une déformation localement variable par le biais d'un premier ensemble d'électrodes se trouvant du côté de la couche piézoélectrique qui est dirigé vers l'empilement de couches réfléchissantes et d'un deuxième ensemble d'électrodes se trouvant du côté de la couche piézoélectrique qui est dirigé vers le substrat de miroir ;
• au moins un de ces ensemble d'électrodes étant associé à une couche médiatrice (27, 37) ayant une conductivité électrique commandable pour régler de manière variable dans le temps une évolution continue du potentiel électrique le long de l'ensemble d'électrodes respectif.

7. Miroir selon la revendication 6, **caractérisé en ce que** cette au moins une électrode de commande (30, 30a, 30b, 30c,...) comporte en particulier une pluralité d'électrodes de commande (30a, 30b, 30c,...) actionnables indépendamment pour commander la conductivité électrique de la couche médiatrice (27, 37).

8. Miroir selon l'une des revendications précédentes, **caractérisé en ce que** le miroir est conçu pour une longueur d'onde de fonctionnement inférieure à 30 nm, notamment inférieure à 15 nm.

9. Miroir selon l'une des revendications précédentes, **caractérisé en ce que** ledit miroir est un miroir destiné à une installation d'exposition par projection microlithographique.

10. Système optique, notamment dispositif d'éclairement ou objectif de projection d'une installation d'exposition par projection microlithographique, **caractérisé en ce que** le système optique comporte un miroir selon l'une des revendications précédentes.

11. Système optique, notamment dispositif d'éclairement ou objectif de projection d'une installation d'exposition par projection microlithographique, ledit système comprenant au moins deux miroirs, chacun de ces miroirs ayant une surface optique active, un substrat de miroir et un empilement de couches réfléchissantes destiné à réfléchir le rayonnement électromagnétique incident à la surface optique active ;
• chacun de ces miroirs comportant une couche piézoélectrique qui est disposée entre le substrat de miroir et l'empilement de couches réfléchissantes et qui peut être soumise à un champ électrique pour générer une déformation localement variable par le biais d'un premier ensemble d'électrodes se trouvant du côté de la couche piézoélectrique qui est dirigé vers l'empilement de couches réfléchissantes et d'un deuxième ensemble d'électrodes se trouvant du côté de la couche piézoélectrique qui est dirigé vers le substrat du miroir ;
• chacun de ces miroirs comportant une couche médiatrice destinée à établir une évolution continue du potentiel électrique ; et
• ces couches intermédiaires différant les unes des autres par leur résistance électrique moyenne d'un facteur d'au moins 1,5.

12. Système optique selon la revendication 11, **caractérisé en ce que** ces couches intermédiaires diffèrent les unes des autres par leur résistance électrique moyenne d'un facteur d'au moins 3, notamment d'un facteur d'au moins 5.

13. Installation d'exposition par projection microlithographique (400) comprenant un dispositif d'éclairement et un objectif de projection, **caractérisé en ce que** l'installation d'exposition par projection comporte un système optique selon l'une des revendications 11 à 12.
